# EUROPEAN PATENT SPECIFICATION

(11) **EP 1 465 013 B1**
(45) Date of publication and mention of the grant of the patent: **12.08.2009**
(21) Application number: 04251078.4
(22) Date of filing: 26.02.2004
(51) Int. Cl.: G03F 7/20, H02K 41/02

(54) **Lithographic apparatus and device manufacturing method**
Lithographischer Apparat und Verfahren zur Herstellung eines Artikels
Appareil lithographique et procédé pour la production d'un dispositif

(30) Priority: 11.03.2003 EP 03251455
(43) Date of publication of application: 06.10.2004
(73) Proprietor: ASML Netherlands B.V., 5504 DR Veldhoven (NL)
(72) Inventor: Hol, Sven Antoin Johan, 5623 AW Eindhoven (NL); Compter, Johan Cornelis, 5644 DE Eindhoven (NL); Loopstra, Eirk Roelof, 5591 BA Heeze (NL); Vreugdewater, Patricia, 5658 BC Eindhoven (NL)
(74) Representative: Maas, Abraham Johannes

(56) References cited:
- EP-A- 1 124 160
- US-A- 4 535 278
- US-B1- 6 455 956
- US-B1- 6 471 435
- PATENT ABSTRACTS OF JAPAN vol. 2003, no. 01, 14 January 2003 (2003-01-14) -& JP 2002 272087 A (NIKON CORP), 20 September 2002 (2002-09-20)

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a linear motor for moving one of said support structure and said substrate table.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ―commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In order to reduce the cost of ownership of a lithographic apparatus, which is a very expensive machine, the apparatus must have as high a throughput, measured in wafers exposed per hour, as possible. For a scanning apparatus, an increase in the scanning speed during exposures can provide a substantial increase in throughput. However, the mask and substrate tables, which must be scanned in synchronism, are heavy, weighing several tens of kg each. Already they are moved very quickly, for example the mask table, which must move at four times the speed of the substrate in an apparatus with a projection lens with a magnification of 1/4, is accelerated at about 50ms⁻² in a known apparatus. Thus to increase the scanning speed requires substantially more powerful motors. Existing designs or linear motors, consisting of a magnet plate (stator) and coil block (translator or armature) with 3, 6, 12 or 15 coils, cannot simply be scaled up as this results in excessive heat generation.

JP-A-2002-272087 discloses a linear motor in which the coil unit comprises a plurality of coils not wound about ferromagnetic cores.

It is an object of the present invention to provide an improved linear motor having increased efficiency and hence greater drive force without correspondingly higher heat dissipation.

This and other objects are achieved according to the invention in a lithographic apparatus and a device manufacturing method as defined in the appended claims.

The use of two opposed magnet plates and an open coil unit, *i*.*e*. one in which there is no ferromagnetic connection between the cores of coils of different phases, enables construction of a motor with lower volume for a given force. There may also be an increase in efficiency of the motor because there is additional effective magnet material, and hence higher magnetic forces, whilst the moving mass is reduced. At the same time, the normal force (i.e, the force generated in the direction perpendicular to the driving direction) is reduced by a factor of 500 to 1,000..This provides a substantial additional advantage in that the bearing requirements are greatly reduced, particularly where the motor is to operate in vacuum.

The ferromagnetic cores about which the coils are wound may also be referred to as teeth, as is common practice for linear electromagnetic motors.

In an embodiment of the present invention, the coil unit comprises a plurality of coil sets, each coil set comprising one or more coils and a DC amplifier for each coil set. The different coils per coil set can be connected in series or in parallel. As an alternative to supplying the power by means of a DC amplifier, the coil sets may be powered by a multiphase AC amplifier.

In a preferred embodiment of the invention, the coil unit comprises three coil sets, each coil set comprising one or more coils, and three DC amplifiers, one driving each coil set. A three-phase AC amplifier may also be used.

Also in a preferred embodiment, the ferromagnetic cores about which said coils are wound project beyond said coils, and coolant conduits provided between said cores and in thermal contact with said coils. The coolant conduits are used to circulate a coolant fluid, *e*.*g*. water, during use of the motor and enable efficient cooling without an undue increase in motor size of the moving mass. Efficient cooling enables higher current densities in the coil to be used, allowing an increase in driving force. Preferably, the coolant conduits are formed of a ceramic material, and thereby do not cause any power loss as would occur due to eddy currents in a conductive material.

Also, the coils may be wound with foil and thereby have a high thermal conductivity toward the cooling conduits. The use of foil coils may also provide an improved performance in other electromagnetic motors where the coils are wound about a ferromagnetic core.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e*.*g*, with a wavelength of 365, 248, 193, 157 or 126 nm) and EUV (extreme ultra-violet radiation, *e*.*g*. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 is a cross-section through a first linear motor according to an embodiment of the invention;
Figure 3 is an enlarged cross-section of part of the translator of the motor of Figure 2 showing coolant channels;
Figure 4 is a cross-section through a second linear motor according to an embodiment of the invention; and
Figure 5 is a cross-section through a third linear motor according to an embodiment of the invention.

In the Figures, corresponding reference symbols indicate corresponding parts.

### Embodiment 1

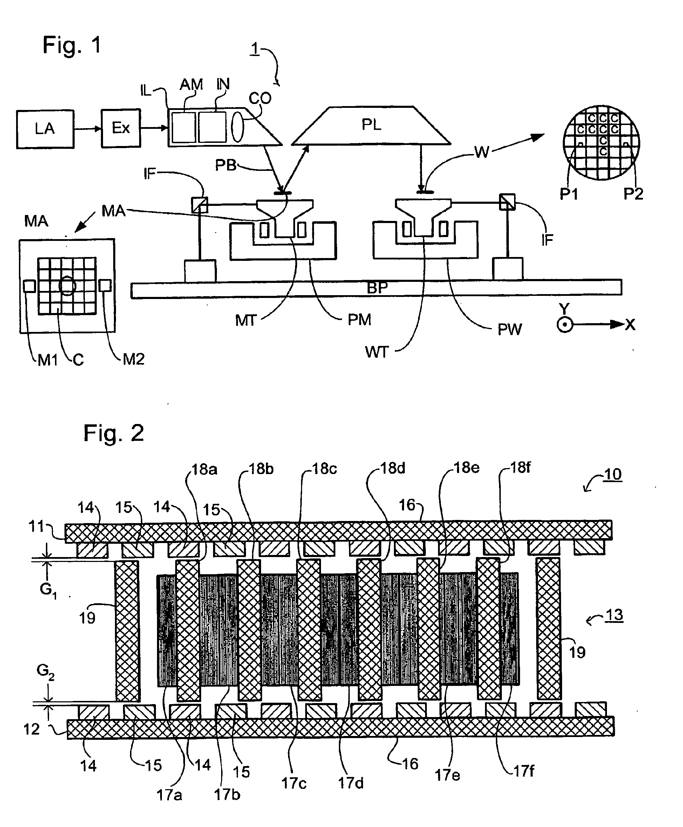

Figure 1 schematically depicts a lithographic projection apparatus according to a particular embodiment of the invention. The apparatus comprises:
a radiation system Ex, IL, for supplying a projection beam PB of radiation (*e.g.* EUV radiation), which in this particular case also comprises a radiation source LA;
a first object table (mask table) MT provided with a mask holder for holding a mask MA (*e.g.* a reticle), and connected to first positioning means for accurately positioning the mask with respect to item PL;
a second object table (substrate table) WT provided with a substrate holder for holding a substrate W (*e.g.* a resist-coated silicon wafer), and connected to second positioning means for accurately positioning the substrate with respect to item PL;
a projection system ("lens") PL (*e.g.* a mirror group) for imaging an irradiated portion of the mask MA onto a target portion C (*e.g*. comprising one or more dies) of the substrate W.
As here depicted, the apparatus is of a reflective type (*e.g.* has a reflective mask). However, in general, it may also be of a transmissive type, for example (*e.g.* with a transmissive mask). Alternatively, the apparatus may employ another kind of patterning means, such as a programmable mirror array of a type as referred to above.

The source LA. (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (*e.g.* with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

In this embodiment, the mask table MT must perform a reciprocating motion for successive scanning exposures and to maintain a relatively high throughput must be accelerated and decelerated rapidly. A powerful motor having a relatively long stroke to drive the mask table in the Y direction is therefore required. According to the invention, a linear motor 10 as shown in Figure 2 is used.

The linear motor 10 comprises opposed magnet plates or tracks 11, 12 and a coil unit (translator or armature) 13. The magnet plates 11, 12 comprise permanent magnets 14, 15, alternately oriented N and S pole up, mounted on a back plane 16. Optionally, Halbach magnets can be placed between the permanent magnets 14, 15. Note that only a part of each of the magnet plates 11, 12 is shown, the length of the magnet tracks will be much longer and determined by the desired stroke of the motor. The coil unit 13 comprises in this example 6 coils 17a-f wound around respective ferromagnetic cores (teeth) 18a-f. Two outer teeth 19 for reducing force ripples during motion and cogging are also provided. The outer teeth 19 may be spaced further from the other cores than the spacing of the other cores and may also be larger, depending on the number of coils. The cores may be formed of laminated, powdered or solid iron or ferromagnetic alloy. A framework (not shown) holds the coils together and connects the coil unit to the driven object.

The six coils 17a-f are grouped together in three interleaved sets - 17a and 17d, 17b and 17e and 17c and 17f. The three sets each comprise one "phase" of the motor, though there is no internal connection and each coil set is driven via a respective DC amplifier. A three-phase AC amplifier may also be used and the coils can be connected in other configurations such as star, delta or independent.

The gaps, G₁, G₂, between the teeth 18a-f and the magnet plates 11, 12 determine the normal forces exerted on the armature 13. To ensure no normal forces the gaps should be made equal. To provide a normal force of a desired magnitude, *e.g.* for bearing purposes or gravity compensation, the sizes of the gaps G₁, G₂ can be set as desired. Mechanical considerations may set a lower limit to the size of the gaps.

The exact materials and dimensions of the motor will be determined according to the use to which it is to be put. The coils 17a-f may be made of copper wire or may be wound of foil (*e.g.* Cu or Al) enabling a filling factor of >0.8. If the magnet pitch is 12mm (N-S), the teeth pitch 16mm, the thickness of the magnets = 4mm and the iron core teeth 6mm x 55mm x 38mm, the motor can provide a drive force of about 670N.

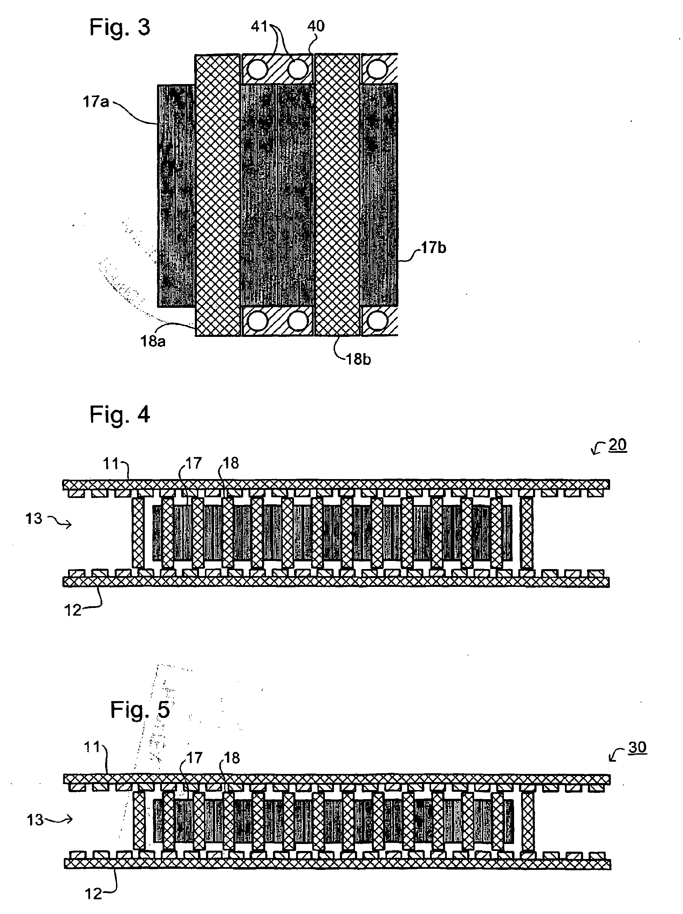

To provide a greater drive force, the number of coils may be increased. A second example is shown in Figure 4. Motor 20 shown in Figure 4 has 12 coils 17 wound around iron teeth 18 and again two outer teeth 19. If made of the same materials and dimensions as the first example, a drive force of 1340N can be achieved.

As shown in Figure 5, representing a third example motor 30, the height of the coils can be reduced, and the current density increased to provide a driving force of 1800N.

To cool the coils, an arrangement as shown in Figure 3 may be employed. Between the teeth 18a, 18b where they extend above the coils 17a, 17b, a ceramic insert 40 is provided. The insert 40 has two conduits 41 within it allowing a coolant, *e.g.* water, to be circulated around the coils. The insert may instead have one or more conduits that are rectangular in cross-section. Because the insert 40 is ceramic, it does not causes losses through eddy currents. Figure 3 shows just two coils 17a, 17b and their respective teeth 18a, 18b but the same arrangement is provided in each of the gaps between teeth.

Whilst the illustrated embodiment has two parallel magnet plates, it will be appreciated that the magnet plates need not be parallel. If the plates are inclined to one another, a force component perpendicular to the bisector of the angle between the plates is produced. This force may be controlled by varying the commutation angle applied to the different phases of the motor.

Whilst specific embodiments of the invention have been described above, it will be appreciated that the invention may be practiced otherwise than as described. In particular, the motor may be used to drive the substrate stage of a lithographic projection apparatus or in any other application where a large drive force is required. Also, one of the magnet plates may be formed as a simple iron plate, with no permanent magnets. The description is not intended to limit the invention.

Also, the aforementioned use of foil coils wound around a ferromagnetic core should not be limited to the specified embodiments but may result in an improved performance in other electromagnetic motors as well. An example of a motor that might benefit from foil coils is a linear motor comprising of a single magnet plate and a coil unit, the coil unit comprising a single ferromagnetic core having a plurality of ferromagnetic teeth and a plurality of coils each wound around respective ferromagnetic teeth. As yet another example, the use of foil coils may also lead to an improved performance of reluctance motors.

## Claims

1. A lithographic projection apparatus comprising:
- a radiation system (IL) for supplying a projection beam of radiation;
- a support structure (MT) for supporting patterning means, the patterning means serving to pattern the projection beam according to a desired pattern;
- a substrate table (WT) for holding a substrate;
- a projection system (PL) for projecting the patterned beam onto a target portion of the substrate; and
- a linear motor (10) for moving one of said support structure and said substrate table; wherein
said linear motor comprises first and second magnet plates (11,12), said magnet plates being opposed to one another, and a coil unit (13) between said magnet plates,
said magnet plates and said coil unit being relatively moveable; **characterized in that:**
said coil unit is open and comprises a plurality of coils (17a-f) wound about respective ferromagnetic cores (18a-f).

2. Apparatus according to claim 1, wherein said coil unit comprises three coil sets, each coil set comprising one or more coils.

3. Apparatus according to claim 1 or 2 wherein said coil unit further comprises at least one additional ferromagnetic member (19) having no coil wound thereon and being spaced from an outermost one of said coils.

4. Apparatus according to claim 1, 2 or 3, wherein the ferromagnetic cores (18a-f) project beyond the coils (17a-f) wound around them, and a coolant conduit (40) is provided between said cores and in thermal contact with said coils.

5. Apparatus according to claim 4 wherein said coolant conduit (40) is formed of a ceramic material.

6. Apparatus according to claim 4 or 5 wherein the coils (17c-f) are wound of foil, *e*.*g*. Cu or Al foil.

7. Apparatus according to any one of the preceding claims wherein said magnet plates (11,12) comprise Halbach magnets.

8. Apparatus according to any one of the preceding claims wherein said first and second magnet plates (11,12) are not mutually parallel and further comprising means for varying the commutation angle applied to coils of said coil unit (13).

9. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material; and
- displacing at least one of the patterning means and the substrate using a linear motor; wherein
- said linear motor comprises first and second magnet plates, said magnet plates being opposed to one another, and a coil unit between said magnet plates, said magnet plates and said coil unit being relatively movable; **characterized in that**:
- said coil unit is open and comprises a plurality of coils (17a-f) wound about respective ferromagnetic cores (18a-f).

## Patentansprüche

1. Lithographische Projektionsvorrichtung, mit:
• einem Strahlungssystem (IL) zum Bereitstellen eines Projektionsstrahls aus Strahlung;
• einer Haltekonstruktion (MT) zum Halten von Musteraufbringungseinrichtungen, wobei die Musteraufbringungseinrichtungen dazu dienen, den Projektionsstrahl gemäß einem gewünschten Muster zu mustern;
• einem Substrattisch (WT) zum Halten eines Substrats;
• einem Projektionssystem (PL) zum Projizieren des gemusterten Strahls auf einen Zielbereich des Substrats; und mit
• einem linearen Motor (10) zum Bewegen von entweder der Haltekonstruktion oder dem Substrattisch;
wobei
der lineare Motor erste und zweite Magnetplatten (11, 12) umfasst, wobei die Magnetplatten einander gegenüberliegend angeordnet sind, und eine Spuleneinheit (13) zwischen den Magnetplatten, wobei die Magnetplatten und die Spuleneinheit relativ bewegbar sind;
**dadurch gekennzeichnet, dass:**
die Spuleneinheit offen ist und eine Vielzahl von Spulen (17a-f) umfasst, die um jeweilige ferromagnetische Kerne (18a-f) gewickelt sind.

2. Vorrichtung nach Anspruch 1, wobei die Spuleneinheit drei Spulensätze umfasst, wobei jeder Spulensatz eine oder mehr Spulen umfasst.

3. Vorrichtung nach Anspruch 1 oder 2, wobei die Spuleneinheit ferner wenigstens ein weiteres ferromagnetisches Element (19) umfasst, das keine aufgewickelte Spule aufweist und von einer äußersten der Spulen beabstandet ist.

4. Vorrichtung nach Anspruch 1, 2 oder 3, wobei die ferromagnetischen Kerne (18a-f) über die um sie gewickelten Spulen (17a-f) hinausragen und
wobei eine Kühlmittelleitung (40) zwischen den Kernen und in Wärmekontakt mit den Spulen vorgesehen ist.

5. Vorrichtung nach Anspruch 4, wobei die Kühlmittelleitung (40) aus einem keramischen Material geformt ist.

6. Vorrichtung nach Anspruch 4 oder 5, wobei die Spulen (17c-f) aus Folie, z.B. Cu- oder Al-Folie gewickelt sind.

7. Vorrichtung nach einem der vorhergehenden Ansprüche, wobei die Magnetplatten (11, 12) Halbach-Magneten umfassen.

8. Vorrichtung nach einem der vorhergehenden Ansprüche, wobei die erste und die zweite Magnetplatte (11, 12) zueinander nicht parallel verlaufen und ferner Einrichtungen zum Variieren des Kommutationswinkels umfassen, der bei Spulen der Spuleneinheit (13) angewendet wird.

9. Verfahren zur Herstellung eines Bauelements, das folgende Schritte umfasst:
• Bereitstellen eines Substrats, das zumindest teilweise von einer Schicht aus strahlungssensitivem Material bedeckt ist;
• Bereitstellen eines Projektionsstrahls aus Strahlung unter Verwendung eines Strahlungssystems;
• Verwenden von Musteraufbringungseinrichtungen, um den Projektionsstrahl in seinem Querschnitt mit einem Muster zu versehen;
• Projizieren des gemusterten Strahls aus Strahlung auf einen Zielbereich der Schicht aus strahlungssensitivem Material; und
• Verschieben von wenigstens entweder den Musteraufbringungseinrichtungen oder dem Substrat unter Verwendung eines linearen Motors;
wobei
der lineare Motor erste und zweite Magnetplatten umfasst, wobei die Magnetplatten einander gegenüberliegend angeordnet sind, und eine zwischen den Magnetplatten angeordnete Spuleneinheit, wobei die Magnetplatten und die Spuleneinheit relativ bewegbar sind; **dadurch**
**gekennzeichnet, dass:**
die Spuleneinheit offen ist und eine Vielzahl von Spulen (17a-f) umfasst, die um jeweilige ferromagnetische Kerne (18a-f) gewickelt sind.

## Revendications

1. Appareil de projection lithographique comprenant :
- un système de rayonnement (IL) pour délivrer un faisceau de projection de rayonnement ;
- une structure de support (MT) pour supporter des moyens de mise en forme, les moyens de mise en forme servant à mettre en forme le faisceau de projection conformément à un motif voulu ;
- une table de substrat (WT) pour maintenir un substrat ;
- un système de projection (PL) pour projeter le faisceau mis en forme sur une partie cible du substrat ; et
- un monteur linéaire (10) pour déplacer un élément parmi ladite structure de support et ladite table de substrat ; dans lequel
ledit moteur linéaire comprend des première et seconde plaques d'aimants (11, 12), lesdites plaques d'aimants étant opposées ligne à l'autre, et une unité de bobine (13) entre lesdites plaques d'aimants, 1 lesdites plaques d'aimants et ladite unité de bobine étant mobiles de manière relative ; **caractérisé en ce que:**
ladite unité de bobine est ouverte et comprend une pluralité de bobines (17a à 17f) enroulées autour de noyaux ferromagnétiques respectifs (18a à 18f) .

2. Appareil selon la revendication 1, dans lequel ladite unité de bobine comprend trois ensembles de bobines, chaque ensemble de bobines comprenant une ou plusieurs bobines.

3. Appareil selon la revendication 1 ou 2 dans lequel ladite unité de bobine comprend en outre au moins un élément ferromagnétique supplémentaire (19) n'ayant aucune bobine enroulée autour de celui-ci et étant écarté de la bobine la plus à l'extérieur parmi lesdites bobines.

4. Appareil selon la revendication 1, 2 ou 3, dans lequel les noyaux ferromagnétiques (18a à 18f) font saillie au-delà des bobines (17a à 17f) enroulées autour d'eux, et une conduite de fluide de refroidissement (40) est agencée entre lesdits noyaux et en contact thermique avec lesdites bobines.

5. Appareil selon la revendication 4 dans lequel ladite conduite de fluide de refroidissement (40) est faite avec une céramique,

6. Appareil selon la revendication 4 ou 5 dans lequel les bobines (17c à 17f) sont enroulées d'une feuille, par exemple une feuille de Cu ou Al.

7. Appareil selon l'une quelconque des revendications précédentes dans lequel lesdites plaques d'aimants (11, 12) comprennent des aimants de Halbach.

8. Appareil selon l'une quelconque des revendications précédentes dans lequel lesdites première et seconde plaques d'aimants (11, 12) ne sont pas mutuellement parallèles et comprennent en outre des moyens pour faire varier l'angle de commutation appliqué aux bobines de ladite unité de bobina (13).

9. Procédé de fabrication d'un dispositif comprenant les étapes de :
- fournir un substrat qui est au moins partiellement recouvert d'une couche de matériau sensible au rayonnement ;
- fournir un faisceau de projection de rayonnement en utilisant un système de rayonnement ;
- utiliser des moyens de mise en forme pour doter le faisceau de projection d'un motif dans sa section transversale ;
- projeter le faisceau do rayonnement mis en forme sur une partie cible de la couche de matériau sensible au rayonnement ; et
- déplacer au moins un élément parmi les moyens de mise en forme et le substrat en utilisant un moteur linéaire ; dans lequel
- ledit moteur linéaire comprend des première et seconde plaques d'aimants, lesdites plaques d'aimants étant opposées l'une à l'autre, et une unité de bobine entre lesdites plaques d'aimants, lesdites Plaques d'aimants et ladite unité de bobine étant mobiles de manière relative ; **caractérisé en ce que :**
- ladite unité de bobine est ouverte et comprend une pluralité de bobines (17a à 17f) enroulées autour de noyaux ferromagnétiques (18a à 18f) respectifs.
